Europäisches Patentamt

European Patent Office

Office européen des brevets

(19)

(11) EP 0 327 051 B2

(12) NEW EUROPEAN PATENT SPECIFICATION

(45) Date of publication and mention
of the opposition decision:
**17.09.1997 Bulletin 1997/38**

(45) Mention of the grant of the patent:
**01.09.1993 Bulletin 1993/35**

(21) Application number: 89101702.2

(22) Date of filing: **01.02.1989**

(51) Int Cl.6: **C23C 16/26**, C30B 29/04

(54) **Diamond and its preparation by chemical vapor deposition method**

Diamant und seine Darstellung durch ein Verfahren mittels Abscheidung aus der Gasphase

Diamant et sa préparation par une méthode de déposition chimique en phase vapeur

(84) Designated Contracting States:
**DE FR GB**

(30) Priority: 01.02.1988 JP 22640/88

(43) Date of publication of application:
**09.08.1989 Bulletin 1989/32**

(73) Proprietor: **SUMITOMO ELECTRIC INDUSTRIES LIMITED**
**Osaka-shi, Osaka 541 (JP)**

(72) Inventors:
• Tanabe, Keiichiro, c/o Sumitomo Electric. Ind.
Itami-shi, Hyogo-ken (JP)
• Imai, Takahiro, c/o Sumitomo Electric Ind.
Itami-shi, Hyogo-ken (JP)
• Fujimori, Naoji, c/o Sumitomo Electric Ind.
Itami-shi, Hyogo-ken (JP)

(74) Representative:
Hansen, Bernd, Dr. Dipl.-Chem. et al
Hoffmann Eitle,
Patent- und Rechtsanwälte,
Postfach 81 04 20
81904 München (DE)

(56) References cited:
EP-A- 0 161 829        EP-A- 0 254 312
EP-A- 0 254 560        US-A- 3 030 187
US-A- 4 434 188

• PATENT ABSTRACTS OF JAPAN, vol. 12, no. 11 (C-468)[2858], 13 January 1988; & JP-A-62 164 878
• PATENT ABSTRACTS OF JAPAN, vol. 10, no. 36 (C-328)[2093], 13 February 1986; & JP-A-60 186 500
• CHEMICAL ABSTRACTS, vol. 94, no. 16, April 1981, Columbus, OH (US); p. 149, no. 124025x#
• PATENT ABSTRACTS OF JAPAN, vol. 10, no. 43 (C-329)[2100], 20 February 1986; & JP-A-60 191 097
• JAPANESE JOURNAL OF APPLIED PHYSICS, vol. 25, no. 6, part II, June 1986, pp. L519-L521, Tokyo, JP; Y.HIROSE et al.:"Synthesis of diamond thin films by thermal CVD using organic compounds"
• Les Editions de Physiques Paris, vol. XV, 1987, pages 63-77 (E-MRS Meeting, June 1987)
• Patent Abstracts of Japan, vol. 10, no. 362 (C-389) (2419)&JP-A-61-158898
• Patent Abstracts of Japan, vol. 7, no. 248 (C-193)(1393) & JP-A-58-135117
• Japanese Journal of Applied Physics, vol. 26, no. 6, 1987, pages L1032-L1034
• Appl. Phys. Lett., vol. 51, no. 10, 1987, pages 737-739
• Proc. SPIE, vol. 683, "Infrared and Optical Transmitting Materials", 1986, pages 127-138

EP 0 327 051 B2

**Description**

BACKGROUND OF THE INVENTION

Field of the Invention

The present invention relates to a diamond film and its preparation by a chemical vapor deposition method. More particularly, the present invention relates to a method for producing the high quality diamond or covering a substrate with the high quality diamond at a high rate. The present invention is applied in various fields which require high heat conductivity, low dielectricity, good optical transmission, high specific elasticity, high strength, good wear resistance, etc, such as window materials, diaphragms, cutting tools, heat sinks, IC bonders and the like.

Description of the Related Art

Hitherto, the diamond is synthesized in a thermodynamically equilibrium state at high temperature under high pressure. Recently, the diamond can be synthesized by a chemical vapor deposition (CVD) method which positively utilizes an non-equilibrium state.

As the CVD methods for synthesizing the diamond, various methods comprising exciting a mixture of a hydrocarbon and a ten time volume of hydrogen with plasma or a heating filament are known. For example, Japanese Patent Kokai Publication No. 91100/1983 discloses a method comprising preheating the mixture of the hydrocarbon and hydrogen with a thermionic emission material kept at a temperature not lower than 1,000°C and introducing the preheated mixture onto a heated substrate surface to deposit the diamond through pyrolysis of the hydrocarbon. Japanese Patent Kokai Publication No. 110494/1983 discloses a method comprising flowing the hydrogen gas through microwave electrodeless discharge, mixing the hydrogen gas with the hydrocarbon and then depositing the diamond on the substrate through pyrolysis of the hydrocarbon. Japanese Patent Kokai Publication no. 3098/1984 discloses a method comprising introducing a microwave in the mixture of the hydrocarbon and hydrogen to generate a plasma, heating a substrate placed in the plasma at a temperature of 300 to 1,300°C to deposit the diamond on the substrate through pyrolysis of the hydrocarbon.

Since the conventional CVD methods for synthesizing the diamond use the mixture essentially consisting of hydrogen and a carbon-containing compound (for example, hydrocarbons), the plasma is stably generated at a comparatively low pressure up to about 6.7 kPa (50 Torr). Therefore, synthesis conditions, synthesis rates and synthesis areas are restricted, which limits application of the diamond synthesis by the CVD methods.

EP-A-0 254 560 and EP-A-0 254 312 disclose processes for the gaseous phase synthesis of diamond by using a thermoelectron-radiating material to form a plasma. Examples in these references disclose forming a diamond from methane, hydrogen and an inert gas at a pressure of around 20 kPa.

US-A-4 434 188 discloses synthesizing diamond by energizing a gaseous mixture of hydrogen, a hydrocarbon gas and an inactive gas by microwave non-electrode discharge. An example of this reference discloses synthesizing diamond from a mixture of hydrogen, methane and argon in a reaction chamber at a pressure of 6.66 kPa. The substrate on which the diamond is formed is placed away from the plasma-generating region.

Appl. Phys. Lett. 51(10), p. 737-739 discloses the preparation of diamond films using Rf induction thermal plasma at a deposition rate of up to 60 $\mu$m/hr.

SUMMARY OF THE INVENTION

An object of the present invention is to provide an improved CVD method for producing a diamond film, by which the diamond with good quality can be produced at a high rate.

This and other objects are accomplished by a method of the present invention which comprises flowing a mixture of hydrogen (A), an inert gas (B) and a carbon-containing compound (C) at a flow rate of 5.1-100 $cm^3$/sec for the mixture and in molar ratios which satisfy the following equations:

$$0.001 \leq \frac{B}{A+B+C} \leq 0.95$$

and

$$0.001 \leq \frac{C}{A+B+C} \leq 0.1,$$

and generating a plasma from the flowing mixture with radiofrequency or microwave with a frequency of at least 1 kHz under pressure of 40 to 101 kPa (300 to 760 Torr.) to form the diamond on a substrate placed in a plasma-generating region.

According to the method of the present invention, the diamond film can be synthesized homogeneously at a rate several hundreds times faster than the conventional methods which use no inert gas on a wide area of, for example, several ten square millimeter.

BRIEF DESCRIPTION OF THE DRAWINGS

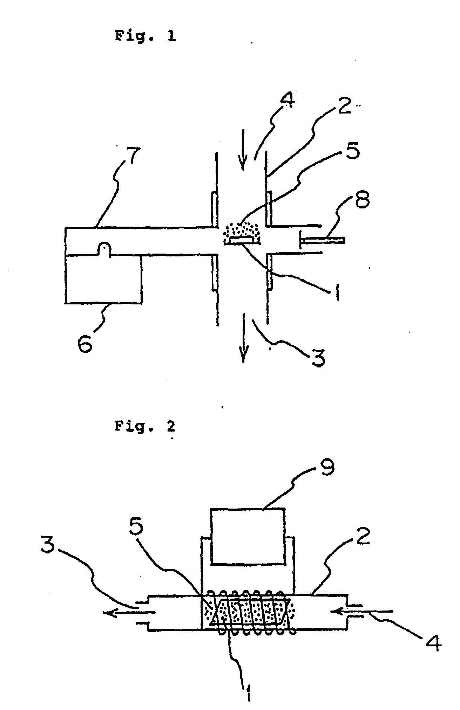

Figs. 1 and 2 schematically respectively show a microwave plasma CVD apparatus and a radio-frequency plasma CVD apparatus.

DETAILED DESCRIPTION OF THE INVENTION

In the method of the present invention, preferably the molar ratios satisfy the equations:

$$0.01 \leq \frac{B}{A+B+C} \leq 0.95$$

and

$$0.002 \leq \frac{C}{A+B+C} \leq 0.08,$$

and the plasma is generated under pressure of 40 to 80 kPa (300 to 600 Torr). More preferably, the molar ratios satisfy the equations:

$$0.05 \leq \frac{B}{A+B+C} \leq 0.8$$

and

$$0.005 \leq \frac{C}{A+B+C} \leq 0.05,$$

and the plasma is generated under pressure of 40 to 53.3 kPa (300 to 400 Torr).

As the plasma generating source, an alternating current electromagnetic field formed from radio-frequency or microwave with a frequency of at least 1 kHz is used because of good operability. The microwave with a frequency of 500 MHz or larger is more preferable. Generally, a making electric power is at least 1 W/cm$^2$.

Examples of the inert gas are helium, neon, argon, krypton, xenon and mixtures thereof. Among them, argon is preferred since it is economically available.

The carbon-containing compound may be any of compounds which comprise at least one carbon atom and are in a gas state under the CVD conditions. Examples of such carbon-containing compound are aliphatic hydrocarbons such as methane, ethane and ethylene, aromatic hydrocarbons such as benzene, inorganic compounds such as carbon monoxide and carbon dioxide and organic compounds having at least one hetero atom (e.g. oxygen, nitrogen and sulfur) such as alcohols, thiols, ketones and ethers.

In the method of the present invention, since the inert gas is present in the plasma generating atmosphere, the plasma with high activity can be stably generated not only at conventional plasma output such as several ten watts or higher but also at relatively low plasma output lower than several ten watts under pressure of from 40 up to 101 kPa. Then, the diamond can be deposited on a surface of three dimensional article on which the deposition of the diamond has been difficult at an appropriate substrate temperature of 700 to 1,200°C since the plasma is concentrated.

The substrate material may be the same as those used in the conventional CVD methods. Preferred substrates include Si, Mo, W, Ta, Nb, Zr, B, C, Al, SiC, $Si_3N_4$, MoC, $Mo_2C$, WC, W2C, TaC, NbC, BN, $B_4C$, AlN, TiC, TiN, Ti, etc.

The plasma with high activity can be confirmed with emission spectral analysis or visual observation. Namely, according to the emission spectral analysis, the plasma with high activity is characterized in that the intensity of the continuous $H_2$ band is relatively weak while the intensities for the hydrogen radicals such as $H(\alpha)$ and $C_2$ and CH radicals are strong. Through the visual observation, greenish emission due to the $C_2$ radical (the Swan band) is often observed. These phenomena indicate that, under the plasma CVD conditions according to the present invention, the raw material gas may be more effectively decomposed than under the conventional conditions.

The effects of the addition of the inert gas are achieved in the pressure range from 40 to 101 kPa (300 to 760 Torr). In general, under lower pressure, the deposition rate of the diamond is smaller, while under higher pressure, the deposition area is decreased since the plasma significantly shrinks. Then, the preferred pressure range is from 40 to 80 kPa (300 to 600 Torr). To increase the deposition rate on a practical deposition area (e.g. several ten square millimeter), the pressure range is preferably from 40 to 53.3 kPa (300 to 400 Torr).

When the raw material mixture contains a doping material (D) such as diborane ($B_2H_6$) and nitrogen ($N_2$) in addition to the hydrogen gas (A), the inert gas (B) and the carbon-containing compound (C), the effects of the addition of the inert gas are achieved in the same way as above. When the doping compound is used, preferably, the molar ratio of the doping material (D) to the total mole of the compounds (A), (B), (C) and (D) satisfy the equation:

$$\frac{D}{A+B+C+D} \leq 0.4$$

When this molar ratio is larger than 0.4, the effects of the present invention are unsatisfactorily achieved.

The observation of the average crystalline particle size (E) in the grown diamond film surface and the film thickness (F) with an optical microscope and a scanning electron microscope has revealed that the average crystalline particle size (E) is large in relation to the film thickness (F). According to the observation with a transmission electron microscope, it has been found that the diamond having the relatively large average crystalline particle size has less crystalline defects such as dislocations or less grain boundaries at which non-diamond materials such as amorphous carbon seem to deposit. This indicates that the diamond of the present invention is a less defective crystal.

The diamond produced by the method of the present invention has various properties which are inherent to the diamond such as high optical transmission which is confirmed through the measurement of transmission spectrum in a range from ultraviolet light to infrared light and large heat conductivity which is confirmed through the measurement of the coefficient of thermal conductivity.

The crystalline particle size has good influences on the property of the diamond, when the thickness (F) is not smaller than 5 μm and the average crystalline particle size (E), measured in μm, and the film thickness (F), measured in μm satisfy the following equation:

$$0.3 \leq E/\sqrt{F} \leq 3.$$

When the ratio $E/\sqrt{F}$ is smaller than 0.3 or larger than 3, the characteristics of the diamond are deteriorated.

According to the method of the present invention, the diamond which satisfy the above equation can be easily produced.

Examples of apparatuses to be used in the method of the present invention are shown in Figs. 1 and 2 which show a microwave plasma CVD apparatus and a radio-frequency plasma CVD apparatus, respectively. In the figures, 1 stands for a substrate, 2 stands for a quartz made reaction tube, 3 stands for an evacuation port, 4 stands for an inlet for introducing the gas mixture, 5 stands for a generated plasma, 6 stands for a magnetron, 7 stands for a waveguide, 8 stands for a plunger and 9 stands for an RF power source. Generally, the reactor tube has a diameter not smaller than 50 mm.

PREFERRED EMBODIMENTS OF THE INVENTION

Example 1

For synthesizing the diamond, the microwave plasma CVD method (hereinafter referred to as "MW-PCVD") was employed (see Tables 1 and 2). The used substrate was a molybdenum plate (40 mm x 35 mm x 10 mm) which had been finally abrased with #600 diamond powder.

In the quartz tube 2, the inert gas specified in Tables 1 and 2 was introduced through the inlet 4. The plasma 5 was generated with the plasma generator under pressure of 0.13 kPa (1 Torr) to clean the molybdenum plate for 5 minutes. Thereafter, the plasma CVD was carried out under the conditions shown in Tables 1 and 2 to cover the molybdenum plate with the synthesized diamond.

During the synthesis of the diamond, the surface temperature of the molybdenum plate was monitored with an optical pyrometer and found to be from 800°C to 1,200°C.

On the diamond synthesized by the plasma CVD method, the surface condition and film thickness were observed with the scanning electron micrometer, and the crystailinity was evaluated with the X-ray diffraction and the Raman spectrometry. The results are shown in Table 3, in which "Dia" and "a-c" represent the diamond and the amorphous carbon, respectively.

When the molar ratio of the inert gas to the total mole of the gasses, the molar ratio of the carbon-containing compound to the total mole of the gasses and the reaction pressure are all in the ranges defined by the present invention, the deposition rate of the diamond can be increased greatly, for example, up to 400 µm/h. On the contrary, outside the ranges of the present invention, the plasma cannot be stably generated under high pressure in the absence of the inert gas. If the plasma can be generated, the produced diamond has inferior properties such that it contains the amorphous carbon, and the deposition rate will be at most 2 µm/h.

Table 1

| Sam-ple No. | CVD | Gases (SCCM) | | | Molar ratio B/(A+B+C) | Molar ratio C/(A+B+C) | Pressure (Torr) kPa | Time (h) |
|---|---|---|---|---|---|---|---|---|
| | | H$_2$ (A) | Inert gas (B) | C-cont. gas (C) | | | | |
| 2 | MW-PCVD | 2000 | Ar (1000) | CH$_4$ (40) | 0.330 | 0.013 | 40.0(300) | 3 |
| 4 | MW-PCVD | 1000 | He (2000) | CH$_4$ (20) | 0.662 | 0.0066 | 56.3(400) | 1 |
| 5 | MW-PCVD | 1000 | Ar (5000) | CH$_3$OH (20) | 0.831 | 0.0033 | 80.0(600) | 2 |
| C15 | MW-PCVD | 1000 | -- | CH$_4$ (4) | --- | 0.01 | 53.3(400) | 1 |
| C16 | MW-PCVD | 100 | Ar (200) | CH$_4$ (100) | 0.5 | 0.25 | 10.7(80) | 1 |

Table 2

| Sample No. | CVD | Gases (SCCM) | | | | Molar ratio B/(A+B+C) | Molar ratio C/(A+B+C) | Pressure (Torr) kPa | Time (h) |
|---|---|---|---|---|---|---|---|---|---|
| | | $H_2$ (A) | Inert gas (B) | C-cont. gas (C) | | | | | |
| C21 | MW-PCVD | 100 | -- | $CH_4$ | (1) | --- | 0.01 | 5.3(40) | 10 |
| C22 | MW-PCVD | 200 | -- | $CH_4$ | (1.) | --- | 0.005 | 2.7(20) | 100 |

Table 3

| Sample No. | Deposition rate (μm/h) | Film thickness (μm) | X-ray diffraction | Raman spectrometry | Remarks |
|---|---|---|---|---|---|
| 2 | 100 | 300 | Dia | Dia | |
| 4 | 200 | 200 | Dia | Dia | Small deposited area 20 x 20 mm$^2$ |
| 5 | 400 | 800 | Dia | Dia | Small ? deposited area 10 x 10 mm$^2$ |
| C15 | --- | --- | --- | --- | No plasma generated |
| C16 | 20 | 20 | --- | (Dia) + a-c | *1) |

Note: *1) The reaction tube was contaminated. The plasma often stopped.

### Example 2

The diamond film peeled off from the sample No. 4 shown in Table 1 (10 mm x 10 mm x 0.2 mm) was placed on a molybdenum plate (40 mm x 34 mm x 10 mm) and then the MW plasma CVD was carried out thereon for 3 hours at the microwave output of 800 W under pressure of 40.0 kPa (300 Torr) while flowing hydrogen, argon and ethanol at flow rates of 1,000 SCCM, 500 SCCM and 40 SCCM, respectively. The diamond grew in thickness from 0.2 mm to 1 mm. Like the sample No. 4, the produced diamond plate had good crystallinity and the preferential orientation in the (100) direction according to the X-ray diffraction and the Raman spectrometry.

### Claims

1. A method for producing a diamond film which comprises flowing a mixture of hydrogen (A), an inert gas (B) and a carbon-containing compound (C) at a flow rate of 5.1 - 100cm$^3$/sec for the mixture and in molar ratios which satisfy the following equations:

$$0.001 \leq \frac{B}{A+B+C} \leq 0.95$$

and

$$0.001 \leq \frac{C}{A+B+C} \leq 0.1,$$

and generating a plasma from the flowing mixture with radiofrequency or microwave with a frequency of at least 1kHz under a pressure of 40 to 101 kPa (300 to 760 Torr) to form the diamond on a substrate placed in the plasma-generating region.

2. The method according to claim 1, wherein the molar ratios of the compounds (A), (B) and (C) satisfy the following equations:

$$0.01 \leq \frac{B}{A+B+C} \leq 0.95$$

and

$$0.002 \leq \frac{C}{A+B+C} \leq 0.08,$$

and the pressure is 40 to 80 kPa (300 to 600 Torr).

3. The method according to claim 1, wherein the molar ratios of the compounds (A), (B) and (C) satisfy the following equations:

$$0.05 \leq \frac{B}{A+B+C} \leq 0.8$$

and

$$0.005 \leq \frac{C}{A+B+C} \leq 0.05,$$

and the pressure is 40 to 53.3 kPa (300 to 400 Torr).

4. The method according to claim 1, wherein the inert gas is at least one selected from the group consisting of helium, neon, argon, krypton and xenon.

5. The method according to claim 4, wherein the inert gas is argon.

6. The method according to claim 1, wherein the carbon-containing compound is a hydrocarbon.

7. The method according to claim 1, wherein the carbon-containing compound is carbon monoxide or carbon dioxide.

8. The method according to claim 1, wherein the carbon-containing compound is an organic compound having at least one hetero atom.

9. The method according to claim 1, wherein the mixture of the compounds (A), (B) and (C) further comprises a doping compound (D).

10. The method according to claim 1, wherein the molar ratio of the doping compound (D) to the total mole of the compounds (A), (B), (C) and (D) is not larger than 0.4.

**Patentansprüche**

1. Verfahren zur Herstellung eines Diamantfilms, das umfaßt: Durchleiten einer Mischung aus Wasserstoff (A), einem Inertgas (B) und einer Kohlenstoff-haltigen Verbindung (C) in Molverhältnissen, welchen den folgenden Gleichungen genügen:

$$0{,}001 \leq \frac{B}{A+B+C} \leq 0{,}95$$

und

$$0{,}001 \leq \frac{C}{A+B+C} \leq 0{,}1,$$

und Erzeugen eines Plasmas mit einer Radiofrequenz oder einer Mikrowelle mit einer Frequenz von mindestens 1 kHz unter einem Druck von 40 bis 101 kPa (300 bis 760 Torr) unter Bildung des Diamanten auf einem in einer Plasma erzeugenden Region angeordnetem Substrat.

2. Verfahren nach Anspruch 1, worin die Molverhältnisse der Verbindungen (A), (B) und (C) den folgenden Gleichungen genügen:

$$0{,}01 \leq \frac{B}{A+B+C} \leq 0{,}95$$

und

$$0,002 \leq \frac{C}{A+B+C} \leq 0,08,$$

und der Druck 40 bis 80 kPa (300 bis 600 Torr) ist.

3. Verfahren nach Anspruch 1, worin die Molverhältnisse der Verbindungen (A), (B) und (C) den Gleichungen:

$$0,05 \leq \frac{B}{A+B+C} \leq 0,8$$

und

$$0,005 \leq \frac{C}{A+B+C} \leq 0,05$$

und der Druck 40 bis 53,3 kPa (300 bis 400 Torr) ist.

4. Verfahren nach Anspruch 1, worin das Inertgas mindestens eines ausgewählt aus Helium, Neon, Krypton und Xenon ist.

5. Verfahren nach Anspruch 4, worin das Inertgas ein Argon ist.

6. Verfahren nach Anspruch 1, worin die Kohlenstoff-haltige Verbindung ein Kohlenwasserstoff ist.

7. Verfahren nach Anspruch 1, worin die Kohlenstoff-haltige Verbindung Kohlenmonoxid oder Kohlendioxid ist.

8. Verfahren nach Anspruch 1, worin die Kohlenstoff-haltige Verbindung eine organische Verbindung mit mindestens einem Heteroatom ist.

9. Verfahren nach Anspruch 1, worin die Mischungen der Verbindungen (A), (B) und (C) zusätzlich eine Dotierungsverbindung (D) enthält.

10. Verfahren nach Anspruch 1, worin das Molverhältnis der Dotierungsverbindung (D) zum Gesamtmolgehalt der Verbindungen (A), (B), (C) und (D) nicht größer als 0,4 ist.

## Revendications

1. Procédé pour produire un film de diamant qui comprend la circulation d'un mélange d'hydrogène (A), d'un gaz inerte (B) et d'un composé carboné (C) à un débit de 5,1-100 cm$^3$/s pour le mélange et dans des proportions molaires satisfaisant les équations suivantes :

$$0,001 \leq \frac{B}{A + B + C} \leq 0,95$$

et

$$0,001 \leq \frac{C}{A + B + C} \leq 0,1$$

et la production d'un plasma à partir du mélange qui circule par une fréquence radio ou des micro-ondes d'une fréquence d'au moins 1 kHz sous une pression de 40 à 101 kPa (300 à 760 mmHg) pour former le diamant sur un support placé dans la zone de production du plasma.

2. Procédé selon la revendication 1, dans lequel les proportions molaires des composés (A), (B) et (C) satisfont les équations suivantes :

$$0{,}01 \leq \frac{B}{A + B + C} \leq 0{,}95$$

et

$$0{,}002 \leq \frac{C}{A + B + C} \leq 0{,}08$$

et la pression est de 40 à 80 kPa (300 à 600 mmHg).

3. Procédé selon la revendication 1, dans lequel les proportions molaires des composés (A), (B) et (C) satisfont les équations suivantes :

$$0{,}05 \leq \frac{B}{A + B + C} \leq 0{,}8$$

et

$$0{,}005 \leq \frac{C}{A + B + C} \leq 0{,}05$$

et la pression est de 40 à 53,3 kPa (300 à 400 mmHg).

4. Procédé selon la revendication 1, dans lequel le gaz inerte est au moins un gaz choisi parmi l'hélium, le néon, l'argon, le krypton et le xénon.

5. Procédé selon la revendication 4, dans lequel le gaz inerte est l'argon.

6. Procédé selon la revendication 1, dans lequel le composé carboné est un hydrocarbure.

7. Procédé selon la revendication 1, dans lequel le composé carboné est le monoxyde de carbone ou le dioxyde de carbone.

8. Procédé selon la revendication 1, dans lequel le composé carboné est un composé organique ayant au moins un hétéroatome.

9. Procédé selon la revendication 1, dans lequel le mélange des composés (A), (B) et (C) comprend en outre un composé dopant (D).

10. Procédé selon la revendication 1, dans lequel le rapport molaire du composé dopant (D) au total des composés (A), (B), (C) et (D) n'est pas supérieur 0,4.

Fig. 1

Fig. 2